# FASCICULE DE BREVET EUROPEEN

(11) **EP 3 483 890 B1**
(45) Date de publication et mention de la délivrance du brevet: **23.02.2022**
(21) Numéro de dépôt: 18204452.9
(22) Date de dépôt: 05.11.2018
(51) Int. Cl.: G11C 13/00, H01L 45/00

(54) **POINT MÉMOIRE À MATÉRIAU À CHANGEMENT DE PHASE**
SPEICHERPUNKT AUS EINEM MATERIAL MIT PHASENÄNDERUNG
MEMORY POINT WITH PHASE-CHANGE MATERIAL

(30) Priorité: 09.11.2017 FR 1760542
(43) Date de publication de la demande: 15.05.2019
(73) Titulaire: STMicroelectronics (Crolles 2) SAS, 38920 Crolles (FR)
(72) Inventeur: HINSINGER, Olivier, 38530 BARRAUX (FR)
(74) Mandataire: Cabinet Beaumont

(56) Documents cités:
- US-A1- 2012 211 720
- US-A1- 2015 280 117
- US-A1- 2017 018 708

## Description

### Domaine

La présente demande concerne les puces électroniques, et plus particulièrement, dans une puce électronique, un point mémoire non volatile à matériau à changement de phase.

### Exposé de l'art antérieur

Dans un point mémoire à matériau à changement de phase, le matériau à changement de phase, par exemple un chalcogénure, est couplé à un élément résistif de chauffage. Pour programmer un tel point mémoire, on chauffe le chalcogénure initialement à l'état cristallin pour en faire fondre une partie. Après arrêt du chauffage, la partie fondue se refroidit suffisamment vite pour devenir amorphe. Pour effacer le point mémoire, on chauffe le chalcogénure sans le faire fondre, afin que la partie amorphe recristallise. La lecture de l'état du point mémoire, programmé ou effacé, utilise la différence entre la conductivité électrique du chalcogénure amorphe et celle du chalcogénure cristallin.

Les demandes de brevet US 2015/280117, US 2017/018708, et US 2012/211720 décrivent des points mémoire à matériau à changement de phase. Les points mémoire à matériau à changement de phase connus présentent divers inconvénients tels qu'un courant élevé pour la programmation, et divers problèmes de compacité. Ces problèmes sont cruciaux par exemple pour une puce électronique comprenant plusieurs millions, voire plusieurs milliards, de tels points mémoire.

### Résumé

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique en coupe d'un point mémoire à matériau à changement de phase ;
les figures 2A à 2D sont des vues en coupe illustrant des étapes de réalisation d'éléments du point mémoire de la figure 1 ; et
les figures 3A à 3I illustrent schématiquement des étapes d'un mode de réalisation d'un procédé de fabrication d'un point mémoire à matériau à changement de phase.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position relative tels que les termes "dessus", "dessous", "supérieur", "inférieur", etc., ou à des qualificatifs tels que les termes "horizontal", "vertical", etc., il est fait référence à l'orientation de l'élément concerné dans les figures autres que 3G et 3I, étant entendu que, dans la pratique, les dispositifs décrits peuvent être orientés différemment. Sauf précision contraire, l'expression "de l'ordre de" signifie à 10 % près, de préférence à 5 % près.

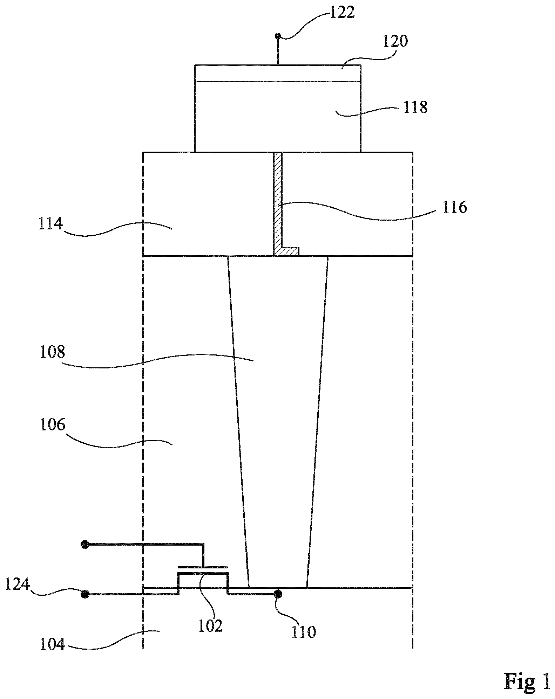

La figure 1 est une vue schématique en coupe d'un point mémoire à matériau à changement de phase.

Conformément à la présente invention, un appareil, selon la revendication 1 et un procédé de fabrication d'un appareil, selon la revendication 7 sont fournis. Des modes de réalisation préférés de l'invention sont revendiqués dans les revendications dépendantes.

Un transistor 102, par exemple de type MOS, mais pouvant aussi être bipolaire, est situé dans et sur un support semiconducteur 104. Ce transistor est représenté de façon symbolique. Le transistor 102 et le support 104 sont recouverts d'une couche 106 électriquement isolante, par exemple en oxyde de silicium. Un via électriquement conducteur 108 traverse verticalement la couche 106 de part en part et a son extrémité inférieure en contact avec le drain 110 du transistor 102. Le sommet du via 108 affleure par exemple la surface supérieure de la couche 106.

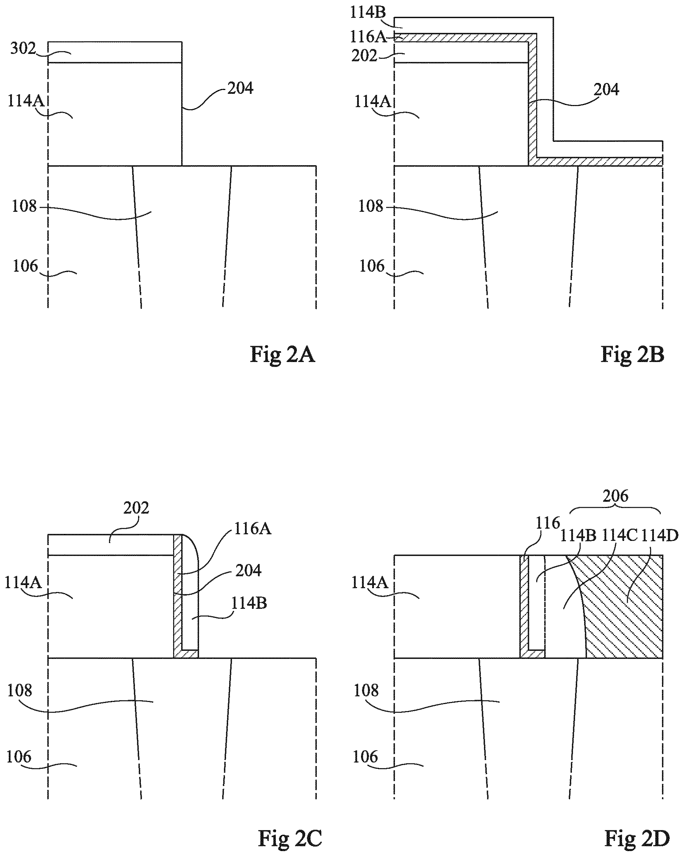

La couche 106 et le via 108 sont recouverts d'une couche électriquement isolante 114, traversée de part en part par un élément résistif 116 disposé sur le via 108. L'élément résistif 116 est destiné au chauffage d'un matériau à changement de phase 118 surmontant l'élément de chauffage 116 et la couche isolante 114. Cet élément résistif de chauffage 116 est par exemple en nitrure de silicium et de titane TiSiN, et a typiquement une forme allongée verticalement. La hauteur de l'élément de chauffage 116 est par exemple comprise entre 30 et 150 nm. Un exemple d'élément de chauffage 116 et de couche isolante 114 est décrit ci-après en relation avec la figure 2D.

Le matériau à changement de phase 118 est recouvert d'une prise de contact 120 reliée à un noeud 122. Le matériau à changement de phase 118, l'élément de chauffage 116 et le transistor 102 se trouvent ainsi reliés électriquement en série entre le noeud 122 et la source 124 du transistor 102.

Les figures 2A à 2D sont des vues en coupe schématiques illustrant des étapes successives de réalisation de l'élément de chauffage 116 et de la couche isolante 114 du point mémoire de la figure 1. La couche isolante 114 obtenue est illustrée en figure 2D de manière plus détaillée qu'en figure 1. On a formé auparavant les éléments du point mémoire situés sous le niveau supérieur de la couche isolante 106.

A l'étape de la figure 2A, on dépose successivement une couche 114A de nitrure de silicium recouvrant la couche 106 et le sommet du via 108, puis une couche 202 d'oxyde de silicium recouvrant la couche 114A. On grave ensuite une partie des couches 202 et 114A sur toutes leurs épaisseurs de sorte que la partie restante des couches 202 et 114A présente un flanc vertical 204 à l'aplomb du via 108.

A l'étape de la figure 2B, on dépose sur la structure obtenue à la figure 2A une couche 116A du matériau du futur élément de chauffage 116. L'élément de chauffage 116 sera formé d'une partie de la couche 116A. La couche 116A est déposée d'une manière conforme, c'est-à-dire déposée sur toutes les parties exposées de la structure. La couche 116A recouvre ainsi le flanc 204. Sur le flanc 204, l'épaisseur de la couche 116A est par exemple comprise entre 2 et 10 nm. On recouvre ensuite la structure d'une couche de nitrure de silicium, de manière conforme.

A l'étape de la figure 2C, on retire les parties horizontales de la couche de nitrure de silicium. La partie restante de la couche constitue un espaceur 114B. On retire ensuite les parties exposées de la couche 116A. La partie restante de la couche 116A comprend une portion verticale contre le flanc 204.

A l'étape de la figure 2D, on forme un espaceur 114C en nitrure de silicium contre l'espaceur 114B. Il reste à côté de l'espaceur 114C une région 206 où la couche 106 est exposée. On dépose dans cette région 206 une couche 114D d'oxyde de silicium d'épaisseur au moins égale à celle de la couche 114A. On retire ensuite tous les éléments de la structure situés au-dessus du niveau supérieur de la couche 114A, par exemple par polissage mécanochimique.

On obtient le point mémoire complet à une étape ultérieure. La portion restante de la couche 114A de nitrure de silicium, les espaceurs 114B et 114C, et la portion restante de la couche 114D, correspondent à la couche isolante 114 du point mémoire. La portion verticale restante de la couche 116A correspond à l'élément de chauffage 116 du point mémoire.

On note que l'utilisation de nitrure de silicium pour la couche 114A et pour les espaceurs 114B et 114C permet que l'élément de chauffage 116 soit uniquement au contact de nitrure de silicium. On évite ainsi un contact entre l'élément de chauffage et un matériau tel que l'oxyde de silicium, en particulier celui de la couche 114D. Un tel contact serait susceptible d'altérer le matériau de l'élément de chauffage, si l'élément de chauffage est par exemple en TiSiN.

Pour programmer ou effacer le point mémoire, on sélectionne le point mémoire en rendant le transistor 102 passant, et on applique une tension entre le noeud 122 et la source 124. Un courant passe dans l'élément de chauffage 116, ce qui produit de la chaleur, et la température de l'élément de chauffage s'élève fortement. Le matériau à changement de phase au contact de l'élément de chauffage 116 fond (pour la programmation) ou recristallise (pour l'effacement).

Un problème est qu'une partie de la chaleur produite n'est pas utilisée pour élever la température de l'élément de chauffage 116 et ainsi faire fondre ou recristalliser le matériau 118, mais est absorbée par les matériaux environnant l'élément de chauffage, en particulier par le nitrure de silicium de la couche 114A. Il faut alors produire beaucoup de chaleur pour obtenir dans l'élément de chauffage 116 une température suffisante pour que le point mémoire soit programmé ou effacé. Il en résulte le problème, évoqué en préambule, de courants de programmation et d'effacement élevés. Le transistor 102 doit être de grande taille pour permettre le passage de ces courants, ce qui pose un problème de compacité. Ce problème de compacité se pose en particulier pour des points mémoire voisins les uns des autres, typiquement, des points mémoire disposés en matrice.

Un autre problème se pose dans le cas de points mémoire voisins. En effet, lors de la programmation d'un des points mémoire, la chaleur produite dans l'élément de chauffage est propagée, en particulier par la portion 114A en nitrure de silicium, jusqu'à un point mémoire voisin qui peut être à l'état programmé. De ce fait, le point mémoire voisin s'échauffe. On doit alors prévoir entre les points mémoire une distance suffisante pour limiter cet échauffement, afin d'éviter que cet échauffement provoque l'effacement du point mémoire voisin.

Pour résoudre ces problèmes, on propose ici que l'élément de chauffage soit totalement encadré d'oxyde de silicium. En effet, l'oxyde de silicium a une conductivité thermique faible, inférieure à une valeur de l'ordre de 1,5 W/(m·K), soit par exemple 10 à 40 fois plus faible que celle du nitrure de silicium (qui peut être par exemple de l'ordre de 17 W/(m·K)). Pour cela, on propose notamment de remplacer l'essentiel de la région 114A de nitrure de silicium par de l'oxyde de silicium. On décrit ci-après un procédé permettant en particulier d'obtenir un élément de chauffage totalement encadré latéralement d'oxyde de silicium mais protégé contre tout contact direct avec l'oxyde de silicium.

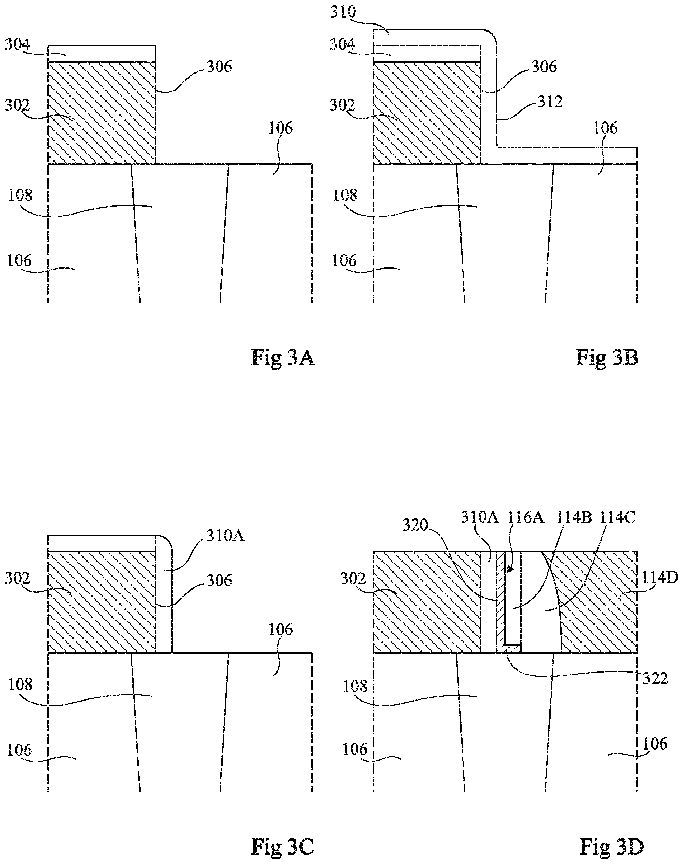

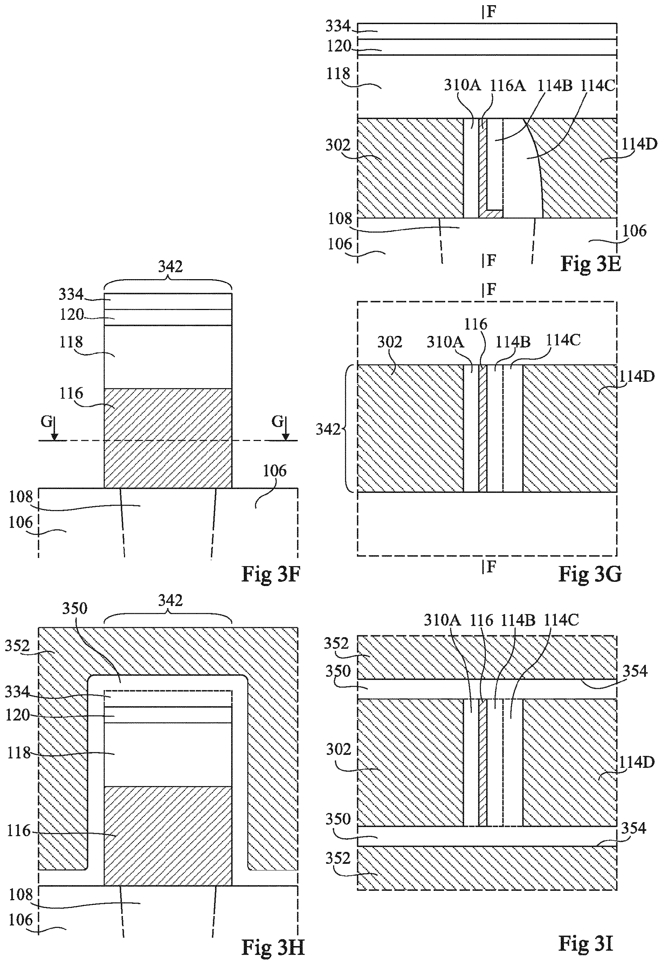

Les figures 3A à 3I illustrent schématiquement des étapes successives d'un mode de réalisation d'un procédé de fabrication d'un point mémoire à matériau à changement de phase. Le point mémoire est par exemple un point mémoire d'une matrice de points mémoire. Les figures 3A à 3E sont des vues en coupe verticale dans la direction des rangées de la matrice. Les figures 3F et 3H sont des vues en coupe verticale dans la direction des colonnes de la matrice. Les figures 3G et 3I sont des vues de dessus en coupe (coupe horizontale).

A l'étape de la figure 3A, on a formé un via 108 traversant une couche isolante 106, tel que décrit en relation avec la figure 1. On recouvre le sommet du via 108 et la couche 106 d'une couche 302. A la différence de la couche 114A de nitrure de silicium des figures 2A à 2D, la couche 302 est en oxyde de silicium. On recouvre la couche 302 d'une couche 304 de nitrure de silicium. A titre d'exemple, l'épaisseur de la couche 302 est comprise entre 30 et 200 nm. L'épaisseur de la couche 304 est par exemple comprise entre 10 et 40 nm.

On grave ensuite une partie des couches 304 et 302 sur toute leur épaisseur de sorte que les parties restantes des couches 304 et 302 aient un flanc vertical 306.

A l'étape de la figure 3B, on dépose de manière conforme une couche 310 de nitrure de silicium. L'épaisseur de la couche 310 est par exemple inférieure à 20 nm, par exemple comprise entre 5 et 30 nm. La couche 310 présente, dans sa partie recouvrant le flanc 306, une face exposée verticale 312. La position du flanc 306 et l'épaisseur de la couche 310 sont prévues pour que la face 312 soit située à l'aplomb du via 308.

A l'étape de la figure 3C, on procède à une gravure anisotrope du nitrure de silicium de manière à retirer les parties horizontales de la couche 310. On obtient un espaceur 310A en nitrure de silicium, situé contre le flanc 306 de la couche d'oxyde de silicium 302.

A l'étape de la figure 3D, on met en oeuvre successivement des étapes similaires à celles décrites en relation avec les figures 2B à 2D, à la différence que les portions des couches 114A et 202 des figures 2B à 2D sont remplacées par les portions des couches 304 et 302 et l'espaceur 310A. On forme ainsi successivement :
- une portion d'une couche 116A en le matériau du futur élément de chauffage contre l'espaceur 310A, recouverte d'un espaceur 114B en nitrure de silicium ;
- un espaceur 114C en nitrure de silicium contre l'espaceur 114B ; et
- une portion 114D de couche d'oxyde de silicium contre l'espaceur 114C. En particulier, on retire tous les éléments situés au-dessus du niveau supérieur de la couche 302. L'élément de chauffage 116A et la couche 302 ont ainsi un même niveau supérieur, c'est-à-dire que le sommet de l'élément de chauffage est dans le plan de la face supérieure de la couche 302.

Dans la structure obtenue, la partie restante de la couche 116A est encadrée latéralement par les deux régions d'oxyde de silicium constituées par les portions de couche 302 et 114D. La partie restante de la couche 116A comprend une portion verticale 320 située contre l'espaceur 310A, et une portion horizontale 322 en dessous de l'espaceur 114B. L'espaceur 114C recouvre le flanc de la portion 322. La partie restante de la couche 116A n'est donc pas en contact avec l'oxyde de silicium de la région 302 ou 114D.

A l'étape de la figure 3E, on dépose une couche en un matériau à changement de phase 118 recouvrant la structure obtenue à l'étape de la figure 3D. On recouvre la couche 118 d'une couche électriquement conductrice 120, par exemple en nitrure de titane, destinée à former une prise de contact sur le matériau à changement de phase. On forme ensuite par exemple une couche de masquage 334 en nitrure de silicium sur la structure. A titre d'exemple, l'épaisseur de la couche 118 est comprise entre 30 et 150 nm. L'épaisseur de la couche 120 est par exemple comprise entre 15 et 50 nm. L'épaisseur de la couche 334 est par exemple comprise entre 5 et 40 nm. A titre de variante, la couche 334 peut être omise.

La figure 3F a pour plan de coupe le plan F-F vertical passant par l'élément de chauffage 116, représenté en figure 3E. A l'étape de la figure 3F, on grave la structure à partir de la surface supérieure de la couche 334 jusqu'au niveau supérieur de la couche 106 en laissant en place une région centrale 342. On a ainsi défini l'élément de chauffage 116, formé de la partie de la couche 116A située dans la bande 342. A titre d'exemple, la largeur de la bande 342 est comprise entre 5 et 50 nm.

La figure 3G est une vue en coupe de la structure obtenue à l'étape de la figure 3F selon un plan horizontal G-G passant par l'élément de chauffage 116. La région centrale a en vue de dessus par exemple la forme d'une bande 342 s'étendant dans la direction des rangées de la matrice de points mémoire. La bande 342 passe sur au moins une partie du via 108.

La figure 3H a pour plan de coupe un plan vertical passant par l'élément de chauffage 116. A l'étape de la figure 3H, on dépose de manière conforme sur la structure une couche 350 de nitrure de silicium. La couche 350 recouvre en particulier les flancs verticaux des éléments situés dans la bande 342. On dépose ensuite une couche 352 d'oxyde de silicium recouvrant la structure et atteignant par exemple un niveau situé au-dessus de celui que la couche 350 atteint dans la région centrale 342.

La figure 3I est une vue en coupe du point mémoire obtenu, selon un plan horizontal passant par l'élément de chauffage 116. L'élément de chauffage 116 est encadré selon une première direction, par exemple la direction des rangées de la matrice de points mémoire, par les régions d'oxyde de silicium 302 et 114D. L'élément de chauffage 116 est en outre encadré selon une deuxième direction, par exemple la direction des colonnes de la matrice, par deux régions de la couche 352. Dans l'exemple illustré en figure 3I, l'élément de chauffage 116 est entre des bords 354 des régions de la couche 352, les bords 354 étant parallèles à la direction des rangées. Les régions 302 et 114D s'étendent entre les bords 354 parallèlement à la direction des rangées, de part et d'autre de l'élément de chauffage.

Du fait que l'élément de chauffage est ainsi encadré latéralement d'oxyde de silicium, qui, comme on l'a indiqué précédemment, est un excellent isolant thermique, on évite, lorsque l'élément de chauffage s'échauffe au cours par exemple de la programmation du point mémoire, que les régions environnant l'élément de chauffage s'échauffent aussi. Il suffit alors d'une quantité réduite de chaleur produite pour que la température de l'élément de chauffage 116 s'élève fortement et que le point mémoire soit programmé ou effacé. Les courants de programmation et d'effacement sont donc réduits.

En outre, les points mémoire voisins de la matrice peuvent être particulièrement proches l'un de l'autre sans qu'il y ait un risque, lors de la programmation d'un point mémoire, d'effacer un point mémoire voisin déjà programmé. En effet, les régions d'oxyde de silicium 302 et 114D permettent de limiter la propagation de chaleur depuis l'élément de chauffage 116 vers les points mémoire voisins de la même rangée de la matrice. Les régions 352 permettent de limiter la propagation de chaleur depuis l'élément de chauffage 116 vers les points mémoire voisins de la même colonne de la matrice.

Comme ceci a été mentionné, l'élément de chauffage 116 est séparé de la région 302 d'oxyde de silicium par l'espaceur 310A en nitrure de silicium, et de la région 114D d'oxyde de silicium par les espaceurs 114B et 114C. L'élément de chauffage 116 est en outre séparé des régions de la couche 352 d'oxyde de silicium par la couche 350 en nitrure de silicium. On évite ainsi des contacts de l'élément de chauffage avec l'oxyde de silicium qui l'encadre.

Des modes de réalisation particuliers ont été décrits. Diverses variantes et modifications apparaîtront à l'homme de l'art. En particulier, dans le procédé des figures 3A à 3I, on peut omettre l'étape de la figure 3E, et à la place de cette étape, former le matériau à changement de phase 118 et la prise de contact 120 à une étape postérieure à l'étape de la figure 3H. Bien qu'à l'étape de la figure 3H, le niveau atteint par la couche 352 soit au-dessus des éléments situés dans la région 342, le niveau supérieur de la couche 352 peut être n'importe quel niveau situé au-dessus de celui du sommet de l'élément de chauffage 116. On a décrit des espaceurs 310A et 114B en nitrure de silicium autour de l'élément de chauffage 116. L'homme de l'art saura choisir d'autres matériaux diélectriques pouvant être disposés au contact de l'élément de chauffage 116 sans l'altérer lors par exemple du chauffage ou par exemple d'une phase de programmation du point mémoire, en particulier sans oxyder l'élément de chauffage.

Bien que, à l'étape de la figure 3F, la région centrale 342 laissée en place au cours de la gravure ait une forme de bande, la région centrale peut avoir toute autre forme adaptée à définir l'élément de chauffage 116 dans la couche 116A par une gravure laissant en place la région centrale.

## Revendications

1. Point mémoire comprenant un élément de chauffage (116) surmonté d'un matériau à changement de phase (118), deux premières régions d'oxyde de silicium (302, 114D) qui encadrent latéralement l'élément de chauffage selon une première direction, deux deuxièmes régions (352) d'oxyde de silicium qui encadrent latéralement l'élément de chauffage selon une deuxième direction orthogonale à la première direction, et deux troisièmes régions en nitrure de silicium chacune séparant l'élément de chauffage de l'une des premières régions, l'une des troisièmes régions consistant en un premier espaceur (310A), et l'autre des troisièmes régions comprenant des deuxième (114B) et troisième (114C) espaceurs,
dans lequel l'élément de chauffage (116) comprend une portion verticale (320) et une portion horizontale (322), le premier espaceur (310A) et le deuxième espaceur (114B) étant en contact avec la portion verticale (320) de l'élément de chauffage, le deuxième espaceur (114B) étant en contact avec la portion horizontale de l'élément de chauffage, et le troisième espaceur (114C) étant en contact avec le deuxième espaceur (114B) et avec un flanc de la portion horizontale (322) de l'élément de chauffage.

2. Point mémoire selon la revendication 1, dans lequel l'élément de chauffage est une partie de couche comprenant une portion verticale (320) et une portion horizontale (322), et les premières régions et l'élément de chauffage ont un même niveau supérieur.

3. Point mémoire selon la revendication 1 ou 2, dans lequel l'élément de chauffage (116) est séparé de chacune des deux deuxièmes régions (352) par une quatrième région (350) de nitrure de silicium.

4. Point mémoire selon l'une quelconque des revendications 1 à 3, dans lequel les deux deuxièmes régions (352) ont des bords parallèles à la première direction, et les premières régions (302, 114D) s'étendent entre lesdits bords parallèlement à la première direction.

5. Point mémoire selon l'une quelconque des revendications 1 à 4, dans lequel l'élément de chauffage est disposé sur un via (108) traversant une couche isolante (106).

6. Puce électronique comprenant un point mémoire selon l'une quelconque des revendications 1 à 5.

7. Procédé de fabrication d'un point mémoire à matériau à changement de phase, comprenant successivement :
a) former une première couche (302) d'oxyde de silicium ;
b) graver partiellement la première couche sur toute son épaisseur en laissant en place une portion de la première couche ;
c) former un premier espaceur (310A) en nitrure de silicium recouvrant un flanc (306) de la portion de la première couche laissée en place à l'étape b) ;
d) former une deuxième couche (116A) en un matériau d'un futur élément de chauffage contre le premier espaceur (310A) ;
e) former une troisième couche en nitrure de silicium, la troisième couche recouvrant la deuxième couche (116A) ;
f) graver partiellement la deuxième couche (116A) et la troisième couche sur toute leur épaisseur en laissant en place une portion de la deuxième couche et une portion de la troisième couche recouvrant le premier espaceur, ladite portion de la troisième couche formant un deuxième espaceur ;
g) former un troisième espaceur (114C) en nitrure de silicium contre le deuxième espaceur ;
h) former, dans les parties gravées à l'étape b), une quatrième couche (114D) en oxyde de silicium d'épaisseur supérieure ou égale à celle de la première couche ;
i) définir l'élément de chauffage (116) dans ladite portion de la deuxième couche, en retirant par gravure des portions de la structure obtenue à l'étape h) qui encadrent l'élément de chauffage ; et
j) former dans les parties gravées à l'étape i) une cinquième couche (352) en oxyde de silicium d'épaisseur supérieure ou égale à celle de la première couche.

8. Procédé selon la revendication 7, comprenant, à l'étape f), laisser en place une portion horizontale de la deuxième couche, et, entre les étapes h) et i), retirer tous les éléments situés au-dessus du niveau supérieur de la première couche.

9. Procédé selon la revendication 7 ou 8, comprenant :
avant l'étape a), former une couche isolante (106) et un via (108) traversant la couche isolante ; et
après l'étape j), former un matériau à changement de phase (118).

10. Procédé selon l'une quelconque des revendications 7 à 9, comprenant, entre les étapes h) et i), la formation d'une manière conforme d'une sixième couche (350) en nitrure de silicium.

11. Procédé selon l'une quelconque des revendications 7 à 10, dans lequel les portions retirées à l'étape i) délimitent une bande (342) s'étendant dans une direction orthogonale audit flanc (306).

## Patentansprüche

1. Eine Speicherzelle mit einem Heizelement (116), das mit einem Phasenänderungsmaterial (118) bedeckt ist, zwei ersten Siliziumoxidbereichen (302, 114D), die das Heizelement seitlich entlang einer ersten Richtung umgeben, zwei zweiten Siliziumoxidbereichen (352), die das Heizelement seitlich entlang einer zweiten Richtung orthogonal zur ersten Richtung umgeben und zwei dritten Siliziumnitridbereichen, die jeweils das Heizelement von einem der ersten Bereiche trennen, wobei einer der dritten Bereiche aus einem ersten Abstandshalter (310A) besteht und der andere der dritten Bereiche zweite (114B) und dritte Abstandshalter (114C) aufweist,
wobei das Heizelement (116) einen vertikalen Abschnitt (320) und einen horizontalen Abschnitt (322) aufweist, wobei der erste Abstandshalter (310A) und der zweite Abstandshalter (114B) den vertikalen Abschnitt (320) des Heizelements berühren, der zweite Abstandshalter (114B) den horizontalen Abschnitt des Heizelements berührt und der dritte Abstandshalter (114C) den zweiten Abstandshalter (114B) und eine Seite des horizontalen Abschnitts (322) des Heizelements berührt.

2. Speicherzelle nach Anspruch 1, wobei das Heizelement ein Schichtabschnitt ist, der einen vertikalen Abschnitt (320) und einen horizontalen Abschnitt (322) aufweist, und die ersten Bereiche und das Heizelement eine gleiche obere Ebene haben.

3. Speicherzelle nach Anspruch 1 oder 2, wobei das Heizelement (116) von jedem der beiden zweiten Bereiche (352) durch einen vierten Siliziumnitridbereich (350) getrennt ist.

4. Speicherzelle nach einem der Ansprüche 1 bis 3, wobei die beiden zweiten Bereiche (352) Kanten aufweisen, die parallel zu der ersten Richtung verlaufen, und die ersten Bereiche (302, 114D) sich zwischen den Kanten parallel zu der ersten Richtung erstrecken.

5. Speicherzelle nach einem der Ansprüche 1 bis 4, wobei das Heizelement an einem Durchgang (108) angeordnet ist, der durch eine Isolierschicht (106) verläuft.

6. Elektronischer Chip mit einer Speicherzelle nach einem der Ansprüche 1 bis 5.

7. Verfahren zur Herstellung einer Speicherzelle aus einem Phasenänderungsmaterial, das nacheinander Folgendes aufweist:
a) Ausbilden einer ersten Siliziumoxidschicht (302);
b) teilweises Ätzen der ersten Schicht über ihre gesamte Dicke, während ein Abschnitt der ersten Schicht an Ort und Stelle verbleibt;
c) Ausbilden eines ersten Siliziumnitrid-Abstandshalters (310A), der eine Seite (306) des in Schritt b) an Ort und Stelle belassenen Abschnitts der ersten Schicht bedeckt;
d) Ausbilden einer zweiten Schicht (116A) aus einem Material eines zukünftigen Heizelements angrenzend an den ersten Abstandshalter (310A);
e) Ausbilden einer dritten Siliziumnitridschicht, wobei die dritte Schicht die zweite Schicht (116A) bedeckt;
f) teilweises Ätzen der zweiten Schicht (116A) und der dritten Schicht über ihre gesamte Dicke, wobei ein Abschnitt der zweiten Schicht und ein Abschnitt der dritten Schicht, die den ersten Abstandshalter bedecken, an Ort und Stelle belassen werden, wobei dieser A der dritten Schicht einen zweiten Abstandshalter bildet;
g) Ausbilden eines dritten Siliziumnitrid-Abstandshalters (114C), der an den zweiten Abstandshalter angrenzt;
h) Ausbilden einer vierten Siliziumoxidschicht (114D) in den in Schritt b) geätzten Abschnitten mit einer Dicke, die größer oder gleich derjenigen der ersten Schicht ist;
i) Ausbilden des Heizelements (116) in dem genannten Abschnitt der zweiten Schicht durch Wegätzen von Teilen der in Schritt h) erhaltenen Struktur, die das Heizelement umgeben; und
j) Ausbilden, in den in Schritt i) geätzten Abschnitten, einer fünften Siliziumoxidschicht (352) mit einer Dicke, die größer oder gleich derjenigen der ersten Schicht ist.

8. Verfahren nach Anspruch 7, bei dem in Schritt f) ein horizontaler Abschnitt der zweiten Schicht an Ort und Stelle belassen wird und zwischen den Schritten h) und i) alle Elemente, die sich über der oberen Ebene der ersten Schicht befinden, entfernt werden.

9. Verfahren nach Anspruch 7 oder 8, wobei das Verfahren Folgendes aufweist:
vor Schritt a), Ausbilden einer Isolierschicht (106) und eines Durchgangs (108), der durch die Isolierschicht verläuft; und
nach Schritt j), Ausbilden eines Phasenänderungsmaterials (118).

10. Verfahren nach einem der Ansprüche 7 bis 9, das zwischen den Schritten h) und i) das konforme Ausbilden einer sechsten Siliziumnitridschicht (350) aufweist.

11. Verfahren nach einem der Ansprüche 7 bis 10, wobei die in Schritt i) entfernten Abschnitte einen Streifen (342) begrenzen, der sich in einer Richtung orthogonal zu der Seite (306) erstreckt.

## Claims

1. A memory cell comprising a heating element (116) topped with a phase-change material (118), two first silicon oxide regions (302, 114D) which laterally surround the heating element along a first direction, two second silicon oxide regions (352) which laterally surround the heating element along a second direction orthogonal to the first direction, and two third silicon nitride regions separating each the heating element from one of the first regions, one of the third regions consisting of a first spacer (310A), and the other of the third regions comprising second (114B) and third spacers (114C),
wherein the heating element (116) comprises a vertical portion (320) and a horizontal portion (322), the first spacer (310A) and the second spacer (114B) contacting the vertical portion (320) of the heating element, the second spacer (114B) contacting the horizontal portion of the heating element, and the third spacer (114C) contacting the second spacer (114B) and a side of the horizontal portion (322) of the heating element.

2. The memory cell of claim 1, wherein the heating element is a layer portion comprising a vertical portion (320) and a horizontal portion (322), and the first regions and the heating element have a same upper level.

3. The memory cell of claim 1 or 2, wherein the heating element (116) is separated from each of the two second regions (352) by a fourth silicon nitride region (350).

4. The memory cell of any of claims 1 to 3, wherein the two second regions (352) have edges parallel to the first direction, and the first regions (302, 114D) extend between said edges parallel to the first direction.

5. The memory cell of any of claims 1 to 4, wherein the heating element is arranged on a via (108) passing through an insulating layer (106).

6. An electronic chip comprising a memory cell of any of claims 1 to 5.

7. A method of manufacturing a phase-change material memory cell, successively comprising:
a) forming a first silicon oxide layer (302);
b) partially etching the first layer across its whole thickness while leaving a portion of the first layer in place;
c) forming a first silicon nitride spacer (310A) covering a side (306) of the portion of the first layer left in place at step b);
d) forming a second layer (116A) of a material of a future heating element adjacent to the first spacer (310A);
e) forming a third silicon nitride layer, the third layer covering the second layer (116A);
f) partially etching the second layer (116A) and the third layer across their whole thickness, while leaving a portion of the second layer and a portion of the third layer covering the first spacer in place, said portion of the third layer constituting a second spacer;
g) forming a third silicon nitride spacer (114C) adjacent to the second spacer;
h) forming, in the portions etched at step b), a fourth silicon oxide layer (114D) having a thickness greater than or equal to that of the first layer;
i) defining the heating element (116) in said portion of the second layer, by etching away parts of the structure obtained at step h) which surround the heating element; and
j) forming in the portions etched at step i) a fifth silicon oxide layer (352) having a thickness greater than or equal to that of the first layer.

8. The method of claim 7, comprising, at step f), leaving a horizontal portion of the second layer in place, and, between steps h) and i), removing all elements located above the upper level of the first layer.

9. The method of claim 7 or 8, comprising:
before step a), forming an insulating layer (106) and a via (108) passing through the insulating layer; and
after step j), forming a phase-change material (118).

10. The method of any of claims 7 to 9 comprising, between steps h) and i), conformally forming a sixth silicon nitride layer (350) .

11. The method of any of claims 7 to 10, wherein the portions removed at step i) delimit a strip (342) extending in a direction orthogonal to said side (306).
